# EUROPÄISCHE PATENTSCHRIFT

(11) **EP 2 489 846 B1**
(45) Veröffentlichungstag und Bekanntmachung des Hinweises auf die Patenterteilung: **06.05.2015**
(21) Anmeldenummer: 12152115.7
(22) Anmeldetag: 23.01.2012
(51) Int. Cl.: H01L 35/30, F01N 13/10, F01N 5/02

(54) **Abgaskrümmer**
Exhaust manifold
Collecteur de gaz d'échappement

(30) Priorität: 16.02.2011 DE 102011004243
(43) Veröffentlichungstag der Anmeldung: 22.08.2012
(73) Patentinhaber: Eberspächer Exhaust Technology GmbH & Co. KG, 66539 Neunkirchen (DE)
(72) Erfinder: Jebasinski, Rolf, 70794 Filderstadt (DE); Wirth, Georg, 73230 Kirchheim/Teck (DE)
(74) Vertreter: BRP Renaud & Partner mbB Rechtsanwälte Patentanwälte Steuerberater

(56) Entgegenhaltungen:
- EP-A1- 2 180 534
- US-A1- 2010 269 878

## Beschreibung

Die vorliegende Erfindung betrifft einen Abgaskrümmer für eine Abgasanlage einer Brennkraftmaschine, insbesondere eines Kraftfahrzeugs, mit den Merkmalen des Oberbegriffs des Anspruchs 1. Die Erfindung betrifft außerdem eine mit wenigstens einem derartigen Angaskrümmer ausgestattete Brennkraftmaschine. Schließlich betrifft die vorliegende Erfindung noch ein Verfahren zum Betreiben einer solchen Brennkraftmaschine.

Abgaskrümmer sind allgemein bekannt und dienen bei Brennkraftmaschinen zum Sammeln und Zusammenführen der von den Zylindern der Brennkraftmaschine abgeführten Abgase. Üblicherweise umfasst ein derartiger Abgaskrümmer einen Abgaskanal zur Abgasführung, der eine an die Brennkraftmaschine anschließbare Einlassseite und eine an die Abgasanlage anschließbare Auslassseite aufweist. Die Einlassseite kann bei Brennkraftmaschine, die mehrere Zylinder aufweisen, eine entsprechende Anzahl an einzelnen Eintassrohren aufweisen, über welche das Abgas-von den Zylindern der Brennkraftmaschine in einen gemeinsamen Sammelbereich des Abgaskanals gelangt. Die Auslassseite umfasst üblicherweise einen gemeinsamen Auslass, über den die Verbindung zur übrigen Abgasanlage hergestellt wird.

Durch die Anordnung des Abgaskrümmers unmittelbar an der Brennkraftmaschine, ist der Abgaskrümmer einer besonders hohen thermischen Belastung ausgesetzt. Es besteht daher das Bedürfnis, die thermische Belastung eines derartigen Abgaskrümmers zu reduzieren und insbesondere die dort vorhandene Wärme zu nutzen.

Aus der US 2010/0269878 A1 ist ein Abgaskrümmer für eine Abgasanlage einer Brennkraftmaschine, insbesondere eines Kraftfahrzeugs, bekannt, umfassend einen Abgaskanal zur Abgasführung, der eine an die Brennkraftmaschine anschließbare Einlassseite und eine an die Abgasanlage anschließbare Auslassseite aufweist, und einen Kühlmittelkanal zur Kühlmittelführung, der außen am Abgaskanal angeordnet und an einen Kühlkreis anschließbar ist, sowie wenigstens einen thermoelektrischen Wandler, der einerseits mit dem Abgaskanal und andererseits mit dem Kühlmittelkanal wärmeübertragend gekoppelt ist.

Ein weiterer Abgaskrümmer ist aus der DE 10 2009 058 948 A1 bekannt.

Aus der EP 2 180 534 A1 ist ein Katalysator bekannt, der Abgaskanäle und Kühlmittelkanäle sowie dazwischen angeordnete thermoelektrische Wandler aufweist.

Aus der WO 2010/112571 A1 ist eine thermoelektrische Generatoreinheit in Form eines Wärmetauschers bekannt, wobei der Wärmetauscher wenigstens einen Abgaskanal, wenigstens einen Kühlmittelkanal und wenigstens einen dazwischen angeordneten thermoelektrischen Wandler aufweist.

Die vorliegende Erfindung beschäftigt sich mit dem Problem, für einen Abgaskrümmer der eingangs genannten Art bzw. für eine damit ausgestattet Brennkraftmaschine eine verbesserte Ausführungsform anzugeben, die sich insbesondere durch eine erhöhte Lebensdauer auszeichnet. Vorzugsweise soll die thermische Belastung des Abgaskrümmers reduziert werden. Ferner ist eine Verbesserung des energetischen Wirkungsgrads der jeweiligen Brennkraftmaschine angestrebt.

Dieses Problem wird erfindungsgemäß durch die Gegenstände der unabhängigen Ansprüche gelöst. Vorteilhafte Ausführungsformen sind Gegenstand der abhängigen Ansprüche.

Die Erfindung beruht auf dem allgemeinen Gedanken, den Abgaskrümmer mit wenigstens einem thermoelektrischen Wandler auszustatten. Mit Hilfe eines derartigen thermoelektrischen Wandlers kann die Temperaturdifferenz zwischen dem Abgaskanal und der Umgebung oder einem Kühlmittelkanal zur Erzeugung einer elektrischen Spannung und somit zum Erzeugen elektrischer Energie genutzt werden. Hierdurch ergibt sich ein enormer zusätzlicher Nutzen für den gekühlten Abgaskrümmer, da elektrische Energie gewonnen werden kann, indem ein Teil der im Abgas mitgeführten Wärme in elektrische Energie gewandelt wird. Somit kann durch den vorgestellten Abgaskrümmer der energetische Wirkungsgrad der damit ausgestatteten Brennkraftmaschine verbessert werden. Darüber hinaus reduziert sich durch die Anbringung des wenigstens einen thermoelektrischen Wandlers die thermische Belastung des Abgaskrümmers, da ein Teil der Wärme in elektrische Energie gewandelt wird. Die Vorteile einer Energierückgewinnung in Form einer Wandlung der Wärme in elektrische Energie im Vergleich zu einem einfachen Abführen der Wärme über den Kühlkreis liegen auf der Hand. Beispielsweise lässt sich die elektrische Energie zwischenspeichern und besonders einfach z.B. in Antriebsenergie wandeln.

Besonders vorteilhaft ist nun eine Ausführungsform, bei welcher der Abgaskrümmer außerdem an einen Kühlkreis angeschlossen ist, um so den Abgaskrümmer aktiv kühlen zu können, was die thermische Belastung des Abgaskrümmers drastisch reduziert. Um den Abgaskrümmer mit Hilfe eines Kühlkreises kühlen zu können, ist der Abgaskrümmer mit wenigstens einem Kühlmittelkanal zur Kühlmittelführung ausgestattet, der außen am Abgaskanal angeordnet ist und der an besagten Kühlkreis anschließbar ist. Insbesondere kann dieser Kühlmittelkanal den Abgaskanal an dessen Außenseite großflächig, insbesondere vollständig oder weitgehend vollständig abdecken bzw. umhüllen. Hierdurch lässt sich besonders viel Wärme übertragen. Bemerkenswert bei dieser Ausführungsform ist außerdem, dass zur Erzielung einer ausreichenden Kühlleistung am bzw. im Abgaskrümmer insgesamt weniger Kühlleistung über den Kühlkreis realisiert werden muss, da ein beachtlicher Teil der Kühlleistung mit Hilfe des jeweiligen thermoelektrischen Wandlers erzeugt werden kann. Somit kann der Kühlbedarf reduziert werden, der über den Kühlkreis bereitgestellt werden muss.

Gemäß einer vorteilhaften Ausführungsform kann eine Steuerung zum Betreiben des wenigstens einen thermoelektrischen Wandlers vorgesehen sein, die während eines Warmbetriebs der Brennkraftmaschine den jeweiligen thermoelektrischen Wandler entsprechend dem Seebeck-Effekt zum Erzeugen elektrischer Energie betreibt bzw. ansteuert und die während eines Kaltstartbetriebs der Brennkraftmaschine den jeweiligen thermoelektrischen Wandler entsprechend dem Peltier-Effekt zum Erzeugen von Wärme betreibt bzw. ansteuert.

Erfindungsgemäß ist zumindest ein solcher Kühlmittelkanal als Druckkörper ausgestaltet und drückt den thermoelektrischen Wandler gegen den Abgaskanal an. Durch dieses gegenseitige Andrücken wird die jeweilige, für die Wärmeübertragung maßgebliche Kontaktfläche zwischen den genannten Komponenten vergrößert bzw. homogenisiert, was den Wärmeübergang zwischen Abgaskanal und thermoelektrischem Wandler einerseits und zwischen Kühlmittelkanal und thermoelektrischem Wandler andererseits verbessert. Das Andrücken des als Druckkörper konfigurierten Kühlmittelkanals kann insbesondere mittels Federkraft realisiert werden, so dass z.B. thermisch bedingte Relativbewegungen einfacher möglich sind.

Ferner weist beim erfindungsgemäßen Abgaskrümmer der jeweilige Kühlmittelkanal zumindest eine Außenschale zum Abstützen von Vorspannkräften und eine Innenschale zum Abstützen des jeweiligen Kühlmittelkanals direkt oder indirekt am jeweiligen thermoelektrischen Wandler auf. Hierdurch besitzt der jeweilige Kühlmittelkanal zumindest einen zweischaligen Aufbau, was die Herstellung vereinfacht. Ferner können Außenschale und Innenschale speziell für die jeweilige Funktion angepasst werden. Beispielsweise kann die Außenschale steifer ausgestaltet sein als die Innenschale, z.B. als Druckplatte. Die Innenschale kann eine Vorspannkontur besitzen, was die Erzeugung der gewünschten Anpresskräfte unterstützt.

Erfindungsgemäß ist zumindest ein Zuganker zum Einleiten der Vorspannkräfte in die jeweilige Außenschale vorgesehen, der am jeweiligen Kühlmittelkanal so angeordnet ist, dass er die Innenschale und die Außenschale durchsetzt und an einer von der Innenschale abgewandten Außenseite der Außenschale abgestützt ist. Somit ist der jeweilige Zuganker platzsparend durch einen Innenraum des Kühlmittelkanals hindurchgeführt, in dem im Betrieb des Abgaskrümmers das jeweilige Kühlmittel geführt ist. Dieser Vorschlag führt zu einer kompakten Bauform.

Bei einer anderen Weiterbildung kann vorgesehen sein, dass der jeweilige Kühlmittelkanal für den jeweiligen Zuganker eine Hülse aufweist, die eine vom jeweiligen Zuganker durchsetzte Durchgangsöffnung von einem vom Kühlmittel durch-strömbaren Innenraum des jeweiligen Kühlmittelkanals trennt. Die jeweilige Hüle erzeugt somit eine gegenüber dem Innenraum fluiddichte Durchführung im jeweiligen Kühlmittelkanal, so dass der jeweilige Zuganker besonders einfach durch die jeweilge Durchgangsöffnung durchführbar ist.

Zweckmäßig können zumindest zwei als Druckkörper ausgestaltete Kühlmittelkanäle vorgesehen sein, zwischen denen der Abgaskanal und der jeweilige thermoelektrische Wandler angeordnet sind und die aufeinanderzu vorgespannt sind, um den thermoelektrischen Wandler gegen den Abgaskanal anzudrücken. Hierdurch können die Vorspannkräfte an den beiden Druckkörpern bzw. an den beiden Kühlmittelkanälen abgetragen werden, ohne dass hierbei eine zusätzliche, insbesondere einseitige, Belastung des Abgaskanals, des jeweiligen thermoelektrischen Wandlers und der Kühlmittelkanäle entsteht. Vorzugsweise sind die beiden Kühlmittelkanäle mittels Federkraft aufeinander zu vorgespannt, so dass auch hier thermisch bedingte Relativbewegungen zwischen den einzelnen Komponenten vereinfacht sind.

Damit der jeweilige Kühlmittelkanal den jeweiligen thermoelektrischen Wandler gegen den Abgaskanal andrücken kann, ist zweckmäßig eine lose Anordnung des thermoelektrischen Wandlers am Abgaskanal und des Kühlmittelkanals am thermoelektrischen Wandler vorgesehen, die Relativbewegungen dieser Komponenten aufeinander zu zulässt.

Besonders vorteilhaft ist dabei eine Ausführungsform, bei welcher zwischen den beiden als Druckkörpern ausgestalteten Kühlmittelkanälen zumindest zwei thermoelektrische Wandler beiderseits des Abgaskanals angeordnet und mit Hilfe der Kühlmittelkanäle gegeneinander angedrückt sind. Somit kann die Wärme am Abgaskanal beidseitig und somit großflächig abgeführt werden. Insoweit kann die thermische Belastung des Gaskanals homogenisiert bzw. symmetrisch gestaltet werden.

Bei einer anderen vorteilhaften Ausführungsform können die beiden Kühlmittelkanäle mit Hilfe von wenigstens einem Zuganker aufeinander zu vorgespannt sein. Unabhängig davon, ob zwei aufeinanderzu vorgespannte Kühlmittelkanäle oder nur ein Kühlmittelkanal vorgesehen ist, können die Materialelastizitäten des Zugankers und/oder des jeweiligen Kühlmittelkanals ausreichend Federelastizität bereitstellen, um thermisch bedingte Relativbewegungen auszugleichen. Zweckmäßig kann jedoch der jeweilige Zuganker zumindest ein Federelement aufweisen oder durch wenigstens ein Federelement gebildet sein, wobei das jeweilige Federelement insbesondere als Wellfeder, als Wellbalgfeder, als C-Feder, als Ω-Feder, als Scheibenfeder oder als Rohrfeder ausgestaltet sein kann. Derartige Federelemente können thermisch bedingte Relativbewegungen zwischen den Kühlmittelkanälen und den damit aufeinander zu vorgespannten Komponenten besonders günstig kompensieren und dabei die erforderliche Vorspannung aufrechterhalten. Zweckmäßig ist dabei der jeweilige Kühlmittelkanäl zumindest relativ zum Abgaskanal in der Vorspannrichtung beweglich angeordnet.

Wie bereits erwähnt kann gemäß einer anderen vorteilhaften Ausführungsform der jeweilige Kühlmittelkanal zumindest eine Außenschale zum Abstützen der Vorspannkräfte, insbesondere an einem weiteren Kühlmittelkanal, und eine Innenschale zum Abstützen des jeweiligen Kühlmittelkanals am jeweiligen thermoelektrischen Wandler aufweisen. Die Ausgestaltung als mehrteiliger Schalenkörper ermöglicht es z.B. die Außenschale als Druckkörper auszugestalten und die Innenschale als Vorspannkörper auszugestalten. Die Außenschale besitzt dann zweckmäßig im Vergleich zur Innenschale eine erhöhte Biegesteifigkeit, während die Innenschale eine Vorspannkontur, z.B. in Form einer dem Abgaskanal zugewandten konvexen Wölbung, besitzen kann. Die Ausgestaltung der Außenschale als Druckplatte vereinfacht die Erzeugung der gewünschten Vorspannung, da eine derartige Druckplatte hinreichend steif und somit selbsttragend konzipiert werden kann. Die federnd nachgiebige Ausgestaltung der Innenschale verbessert die homogene Anpressung des jeweiligen thermoelektrischen Wandlers einerseits gegen den Abgaskanal und andererseits gegen den jeweiligen Kühlmittelkanal.

Entsprechend einer weiteren Ausführungsform kann der jeweilige thermoelektrische Wandler zwischen dem Abgaskanal und dem jeweiligen Kühlmittelkanal von einer thermischen Isolation ringförmig umschlossen sein. Der jeweilige thermoelektrische Wandler steht somit über seine voneinander abgewandten Stirnseiten einerseits mit dem Abgaskanal und andererseits mit dem Kühlmittelkanal wärmeübertragend in Verbindung, während er umfangsseitig thermisch isoliert ist. Hierdurch wird der Wärmestrom auf den jeweiligen thermoelektrischen Wandler konzentriert, was die Effektivität der gesamten Anordnung verbessert. Sofern mehrere thermoelektrische Wandler vorhanden sind, sind benachbarte thermoelektrische Wandler gegeneinander thermisch isoliert. Auch hier führt die vorgesehene thermische Isolierung dazu, dass sich der Wärmestrom auf die einzelnen thermoelektrischen Wandler konzentriert, was den Wirkungsgrad der Anordnung verbessert.

Vorteilhaft können entlang der Außenseite des Abgaskanals verteilt mehrere thermoelektrische Wandler angeordnet sein, die über eine Verkabelung elektrisch miteinander verbunden sind. Die Verwendung mehrerer thermoelektrischer Wandler ermöglicht es, auf im Handel erhältliche, preiswerte thermoelektrische Wandler zurückzugreifen, um diese entlang der Außenseite des Abgaskanals verteilt anordnen zu können. Insbesondere lässt sich hierdurch die Anordnung der thermoelektrischen Wandler an eine beliebige geometrische Form des Abgaskanals adaptieren.

Gemäß einer anderen vorteilhaften Ausführungsform kann der jeweilige thermoelektrische Wandler an eine elektrische Verkabelung angeschlossen sein, die aus dem Abgaskrümmer herausgeführt ist, beispielsweise um den jeweiligen thermoelektrischen Wandler an einen Spannungswandler oder dergleichen anschließen zu können. Die Verkabelung umfasst dabei vorteilhaft ein Metallrohr und wenigstens zwei elektrische Leiter, die elektrisch isoliert sind und im Metallrohr verlegt sind. Hierdurch kann ein effektiver thermischer Schutz für die elektrischen Leiter bzw. für deren elektrische Isolation erzeugt werden. Insbesondere können die Leiter dabei innerhalb des Metallrohrs in eine elektrisch isolierende Masse eingebettet sein. Hierbei kann es sich vorzugsweise um ein elektrisch isolierendes Pulver handeln, das zusammen mit den elektrischen Leitern im Metallrohr verpresst ist. Ein derartiges elektrisch isolierendes Pulver kann beispielsweise aus einer Keramik hergestellt werden, wie z.B. aus Magnesiumoxid.

Entsprechend einer anderen vorteilhaften Ausführungsform kann der Abgaskanal an seiner Innenseite wenigstens eine Versteifungsstruktur zur Aussteifung des Abgaskanals aufweisen. Eine derartige Versteifungsstruktur kann beispielsweise als Sicke oder Rippe oder Steg ausgestaltet sein. Durch die Aussteifung des Abgaskanals können vergleichsweise große Drücke bzw. Vorspannungen erzielt und am Abgaskanal abgestützt werden, um über den jeweiligen Kühlmittelkanal die thermoelektrischen Wandler an den jeweiligen Kühlmittelkanal und an den Abgaskanal anzudrücken. Besonders vorteilhaft ist dabei eine Weiterbildung, bei welcher zumindest eine solche Versteifungsstruktur zwei einander gegenüberliegende Wände des Abgaskanals aneinander abstützt. Hierdurch lassen sich besonders große Kräfte abstützen, während gleichzeitig die Wände des Abgaskanals vergleichsweise dünne Wandstärken aufweisen können.

Zusätzlich oder alternativ kann vorgesehen sein, dass der Abgaskanal an seiner Innenseite wenigstens eine Wärmeübertragungsstruktur zur Verbesserung der Wärmeübertragung zwischen Abgaskanal und Abgas aufweist. Hierdurch kann die Effektivität der Wärmeübertragung und somit der thermoelektrischen Wandler verbessert werden. Geeignete Wärmeübertragungsstrukturen sind z.B. Turbulatoren, Rippen, Lamellen, Leitbleche, Finnen und dergleichen.

Besonders zweckmäßig ist nun eine Variante, bei welcher die zuvor genannte wenigstens eine Versteifungsstruktur zur Aussteifung des Abgaskanals außerdem als eine solche Wärmeübertragungsstruktur zur Verbesserung der Wärmeübertragung zwischen Abgaskanal und Abgas ausgestaltet ist. Hierdurch erhält die Versteifungsstruktur bzw. die Wärmeübertragungsstruktur eine Doppelfunktion, ohne mehr Bauraum zu benötigen.

Das der Erfindung zugrundeliegende Problem wird somit auch mit Hilfe einer Brennkraftmaschine gelöst, die zumindest einen Abgaskrümmer der vorgeschriebenen Art umfasst. Ferner umfasst die Brennkraftmaschine auch wenigstens eine Abgasanlage, die an besagten Abgaskrümmer, nämlich an dessen Auslassseite, angeschlossen ist. Bei dieser Brennkraftmaschine ist der jeweilige Kühlmittelkanal an einen Kühlkreis angeschlossen.

Entsprechend einer anderen vorteilhaften Ausführungsform kann die Brennkraftmaschine einen Kühlkreis, z.B. zur Kühlung eines Motorblocks der Brennkraftmaschine, aufweisen, wobei der jeweilige Kühlmittelkanal zweckmäßig an diesen Kühlkreis der Brennkraftmaschine angeschlossen ist. Es ist klar, dass der jeweilige Kühlmittelkanal des Abgaskrümmers dabei an den Hauptstrang oder an einen Nebenstrang des Kühlkreises der Brennkraftmaschine angeschlossen sein kann.

Alternativ kann bei einer weiteren Ausführungsform vorgesehen sein, dass die Brennkraftmaschine zwar einen Kühlkreis zur Kühlung eines Motorblocks der Brennkraftmaschine aufweisen kann, wobei jedoch der jeweilige Kühlmittelkanal an einen separat vom Kühlkreis der Brennkraftmaschine steuerbaren Kühlkreis angeschlossen ist. Hierbei kann es sich bevorzugt um einen anderen Kühlkreis als den Kühlkreis zum Kühlen des Motorblocks handeln. Ebenso kann es sich um einen separat steuerbaren Nebenkreis des zur Kühlung des Motorblocks vorgesehenen Kühlkreises handeln.

Bei einer anderen Ausführungsform kann zum Beispiel vorgesehen sein, dass der an den jeweiligen Kühlmittelkanal angeschlossene Kühlkreis eine Kühlmittelpumpe aufweist, wobei eine Steuerung vorgesehen ist, die so ausgestaltet bzw. programmiert ist, dass sie eine Förderleistung der Kühlmittelpumpe abhängig vom Kühlbedarf des jeweiligen Kühlmittelkanals steuert. Hierdurch kann die mit Hilfe des jeweiligen thermoelektrischen Wandler generierbare elektrische Energie bedarfabhängig bereitgestellt werden.

Gemäß einer weiteren vorteilhaften Ausführungsform kann ein Abgasturbolader vorgesehen sein, der an einen Kühlkreis angeschlossen ist, an den auch der jeweilige Kühlmittelkanal angeschlossen ist. Sofern ein gekühlter Abgasturbolader vorgesehen ist, der zweckmäßig unmittelbar an den Abgaskrümmer angeschlossen ist, ergibt sich eine extreme Vereinfachung hinsichtlich der Leitungsführung, wenn der jeweilige Kühlmittelkanal des Abgaskrümmers und der Abgasturbolader an denselben Kühlkreis angeschlossen sind.

Das der Erfindung zugrundeliegende Problem wird auch durch ein Verfahren zum Betreiben einer solchen Brennkraftmaschine gelöst. Während eines Warmbetriebs der Brennkraftmaschine, der zumindest dann vorliegt, wenn alle wesentlichen Komponenten ihre übliche Betriebstemperatur erreicht haben, wird der jeweilige thermoelektrische Wandler zum Erzeugen elektrischer Energie betrieben. Mit anderen Worten, die sich während des Warmbetriebs zwischen Abgaskanal und Kühlmittelkanal einstellende Temperaturdifferenz wird unter Ausnutzung des Seebeck-Effekts zum Erzeugen einer elektrischen Spannung und somit zur Abnahme elektrischer Leistung genutzt.

Zumindest während eines Kaltstartbetriebs der Brennkraftmaschine, der zumindest dann vorliegt, wenn beim Starten der Brennkraftmaschine wesentliche Komponenten Umgebungstemperatur besitzen, wird der jeweilige thermoelektrische Wandler invers betrieben, also derart, dass er elektrische Energie in Wärme wandelt und somit zum Beheizen des Abgaskanals beiträgt. Mit anderen Worten, die während des Kaltbetriebs an den jeweiligen thermoelektrischen Wandler angelegte elektrische Spannung wird unter Ausnutzung des Peltier-Effekts zum Erzeugen eines Wärmetransports zwischen Abgaskanal und Kühlmittelkanal genutzt. Somit kann die Zeit, die erforderlich ist, Komponenten der Abgasanlage, die für eine Abgasreinigung relevant sind, auf deren Betriebstemperatur aufzuheizen, reduziert werden, was die Schadstoffemission der Brennkraftmaschine reduziert. Grundsätzlich sind auch während des Warmbetriebs Zustände denkbar, die eine Wärmemeinleitung in den Abgasstrang erforderlich machen, beispielsweise für einen Regenerationsbetrieb einer Abgasbehandlungseinrichtung.

Weitere wichtige Merkmale und Vorteile der Erfindung ergeben sich aus den Unteransprüchen, aus den Zeichnungen und aus der zugehörigen Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in den Zeichnungen dargestellt und werden in der nachfolgenden Beschreibung näher erläutert, wobei sich gleiche Bezugszeichen auf gleiche oder ähnliche oder funktional gleiche Bauteile beziehen.

Es zeigen, jeweils schematisch,
- Fig. 1: eine stark vereinfachte, schaltplanartige Darstellung einer Brennkraftmaschine mit einem Abgaskrümmer,
- Fig. 2: eine Darstellung wie in Fig. 1, jedoch bei einer anderen Ausführungsform der Brennkraftmaschine,
- Fig. 3: eine stark vereinfachte Ansicht des Abgaskrümmers,
- Fig. 4: einen stark vereinfachter Querschnitt des Abgaskrümmers entsprechend Schnittlinien IV in Fig. 3,
- Fig. 5: einen stark vereinfachter Querschnitt des Abgaskrümmers entsprechend Schnittlinien V in Fig. 4.

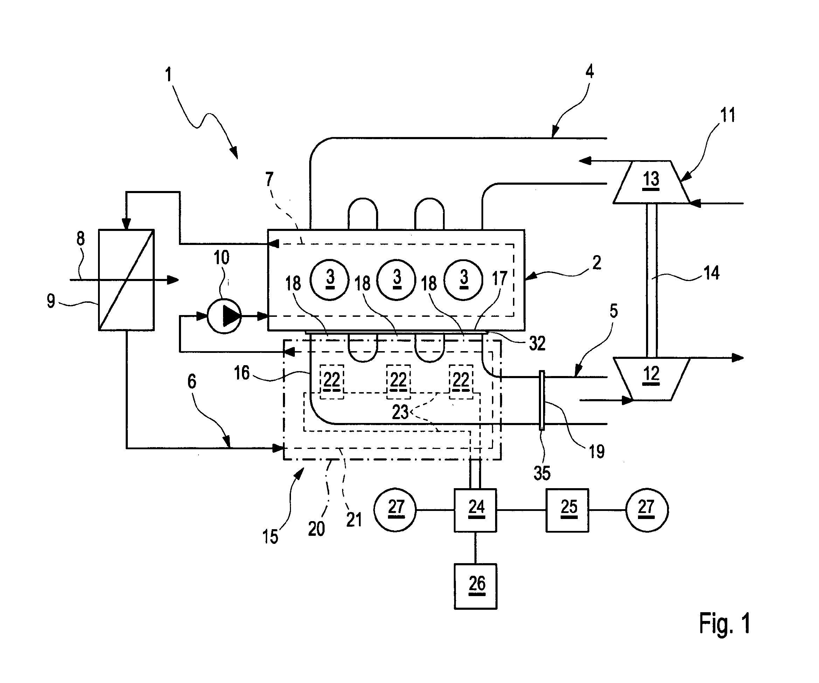

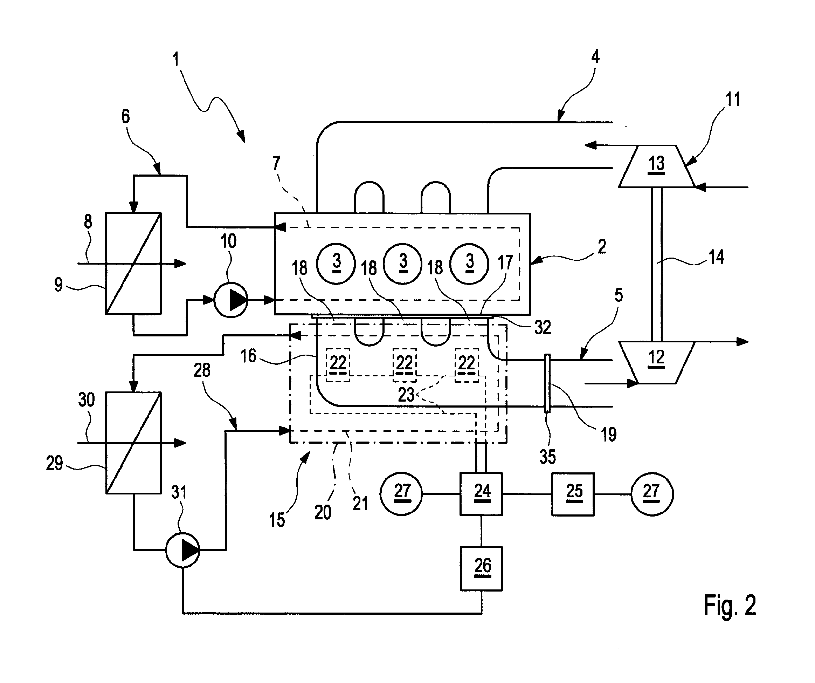

Entsprechend den Fig. 1 und 2 umfasst eine Brennkraftmaschine 1 einen Motorblock 2 mit mehreren Zylindern 3, eine Frischluftanlage 4 zum Zuführen von Frischluft zu den Zylindern 3 und eine Abgasanlage 5 zum Abführen von Abgas von den Zylindern 3. Die Brennkraftmaschine 1 ist ferner mit einem Kühlkreis 6 ausgestattet, der zumindest einen durch den Motorblock 2 geführten Kühlpfad 7 aufweist, einen einer Kühlluftströmung 8 ausgesetzten Kühler 9 enthält sowie eine Pumpe 10 zum Antreiben des Kühlmittels umfasst.

Die Brennkraftmaschine 1 ist im gezeigten Beispiel außerdem mit einem Abgasturbolader 11 ausgestattet, dessen Turbine 12 in die Abgasanlage 5 eingebunden ist, dessen Verdichter 13 in die Frischluftanlage 4 eingebunden ist und dessen Welle 14 in üblicher Weise ein nicht gezeigtes Turbinenrad der Turbine 12 mit einem nicht gezeigten Verdichterrad des Verdichters 13 drehfest verbindet.

Die Abgasanlage 5 ist über einen Abgaskrümmer 15 an den Motorblock 2 angeschlossen. Der Abgaskrümmer 15 umfasst gemäß den Fig. 1 bis 5 einen Abgaskanal 16, der zur Abgasführung von den Zylindern 3 des Motorblocks 2 zur Abgasanlage 5 dient. Der Abgaskanal 16 besitzt eine Einlassseite 17, mit welcher der Abgaskanal 16 an die Brennkraftmaschine 1 bzw. an deren Motorblock 2 anschließbar bzw. angeschlossen ist. Im gezeigten Beispiel umfasst die Einlassseite 17 mehrere Einlassrohre 18, die je einen Zylinder 3 des Motorblocks 2 zugeordnet sind. Ferner umfasst der Abgaskanal 16 eine Auslassseite 19, mit welcher der Abgaskanal 16 an die Abgasanlage 5 anschließbar bzw. angeschlossen ist.

Der Abgaskrümmer 15 umfasst außerdem zumindest einen Kühlmittelkanal 20, der zur Führung eines Kühlmittels dient, der außen am Abgaskanal 16, also an einer vom Abgas abgewandten Seite eingeordnet ist und der an einen Kühlkreis anschließbar bzw. angeschlossen ist. Der jeweilige Kühlmittelkanal 20 definiert einen Kühlmittelpfad 21, der durch den Abgaskrümmer 15 führt.

Im gezeigten Beispiel der Fig. 1 ist der Kühlmittelkanal 20 an den Kühlkreis 6 der Brennkraftmaschine 1 angeschlossen. Im Unterschied dazu zeigt Fig. 2 eine bevorzugte Ausführungsform, bei welcher der jeweilige Kühlmittelkanal 20 an einen vom Kühlkreis 6 der Brennkraftmaschine 1 verschiedenen Kühlkreis 28 angeschlossen ist. Der Kühlmittelkanal 20 ist bei angeschlossenem Kühlkreis 6 bzw. 28 in diesen Kühlkreis 6 bzw. 28 eingebunden. Der zusätzliche Kühlkreis besitzt einen eigenen Kühler 29, der ebenfalls einer Luftströmung 30 ausgesetzt sein kann und der zweckmäßig eine eigene Kühlmittelpumpe 31 aufweist. Diese Kühlmittelpumpe 31 kann zweckmäßig mit einer Steuerung 26 gekoppelt sein, die weiter unten noch näher erläutert wird.

Der Abgaskrümmer 15 ist außerdem mit wenigstens einem thermoelektrischen Wandler 22 ausgestattet. Der jeweilige thermoelektrische Wandler 22 ist einerseits mit dem Abgaskanal 6 und andererseits mit dem Kühlmittelkanal 20 wärmeübertragend gekoppelt. Bei den hier gezeigten Ausführungsformen sind jeweils mehrere derartige thermoelektrische Wandler 22 vorgesehen, die über eine Verkabelung 23 elektrisch miteinander gekoppelt bzw. verbunden sind. Diese Verkabelung 23 ist aus dem Abgaskrümmer 15 herausgeführt und beispielsweise an einen Spannungsrichter oder Spannungskonverter 24 angeschlossen. Der Spannungsrichter 24 kann seinerseits mit einem elektrischen Energiespeicher 25, z.B. in Form einer Batterie, elektrisch verbunden sein, ferner kann eine Steuerung 26 vorgesehen sein, die mit dem Spannungsrichter 24 gekoppelt ist, beispielsweise um diesen anzusteuern. Beliebige elektrische Verbraucher 27 können nun entweder direkt an den Spannungsrichter 24 oder an den Energiespeicher 25 angeschlossen sein.

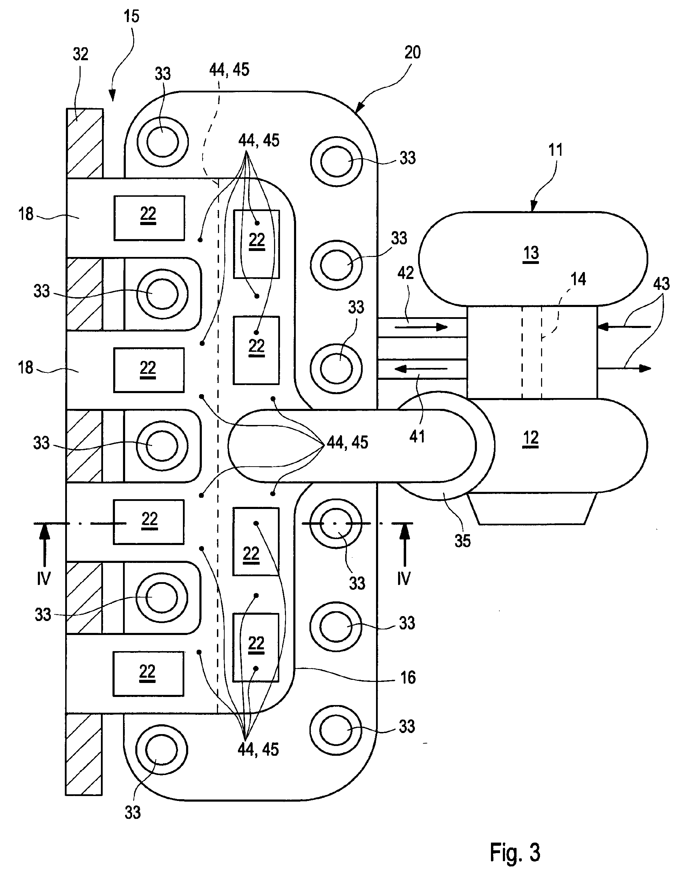

Entsprechend den Fig. 1 bis 4 umfasst der Abgaskrümmer 15 beispielsweise einen Einlassflansch 32, mit dessen Hilfe die Befestigung des Abgaskrümmers 15 am Motorblock 2 realisierbar ist, sowie einen Auslassflansch 35, der die Befestigung des Abgaskrümmers 15 an der Abgasanlage 5 erleichtert. Insbesondere ist es möglich, den Abgaskrümmer 15 gemäß Fig. 3 auslassseitig unmittelbar an die Turbine 12 des Abgasturboladers 11 anzuschließen.

Zumindest einer der Kühlmittelkanäle 20 ist als Druckkörper ausgestaltet. Im Beispiel sind beide Kühlmittelkanäle 20 jeweils als Druckkörper ausgestaltet. Die Kühlmittelkanäle 20 sind außen, also an einer vom Abgas bzw. vom Abgaskanal 16 abgewandeten Seite angeordnet. Die Anbringung des jeweiligen Kühlmittelkanals 20 am Abgaskrümmer 15 erfolgt dabei so, dass durch den Kühlmittelkanal 20 der jeweilige thermoelektrische Wandler 22 gegen den Abgaskanal 15 angedrückt wird. Dieses Andrücken bzw. diese Vorspannung kann insbesondere mittels Federkraft realisiert werden.

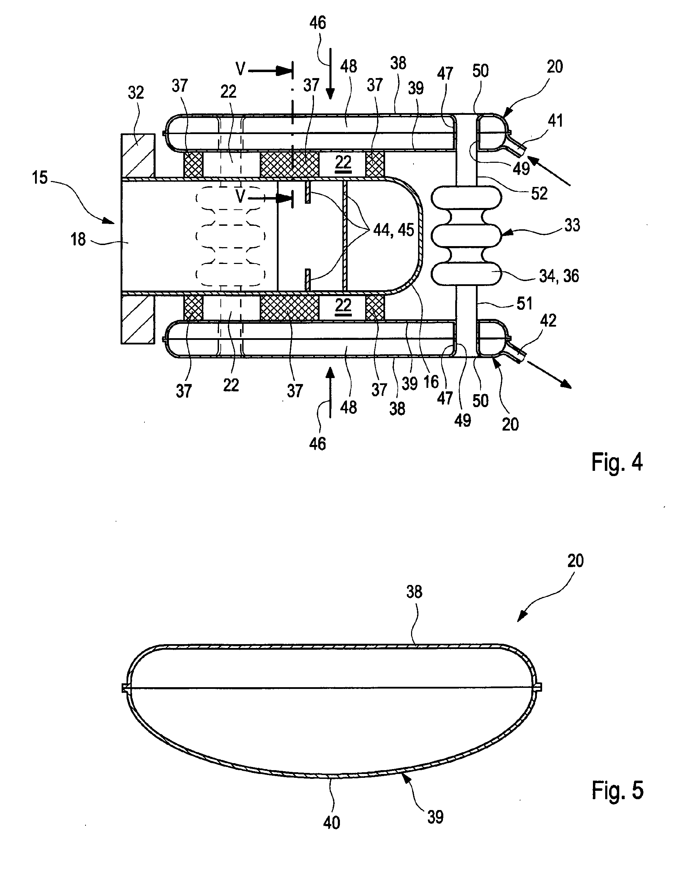

Wie sich insbesondere Fig. 4 entnehmen lässt, sind wenigstens zwei derartige als Druckkörper ausgestaltete Kühlmittelkanäle 20 vorgesehen, wobei der Abgaskanal 16 und der jeweilige thermoelektrische Wandler 22 zwischen diesen beiden als Druckkörper ausgestalteten Kühlmittelkanälen 20 angeordnet sind. Die beiden Kühlmittelkörper 20 sind aufeinander zu vorgespannt, wodurch der Kühlmittelkanal 20 gegen den jeweiligen thermoelektrischen Wandler 22 und der jeweilige thermoelektrische Wandler 22 gegen den Abgaskanal 16 angedrückt sind. Bei den Ausführungsformen der Fig. 3 und 4 sind zwischen den beiden Kühlmittelkanälen 20 jeweils wenigstens zwei thermoelektrische Wandler 22 beiderseits des Abgaskanals 16 beiderseits des Abgaskanals 16 angeordnet und mit Hilfe der Kühlmittelkanäle 20 gegeneinander angedrückt. Im Schnitt der Fig. 4 sind auf jeder Seite des Abgaskanals 16 zwei thermoelektrische Wandler 22 nebeneinander erkennbar.

Zum Erzeugen der Vorspannung der beiden Kühlmittelkanäle 20 gegeneinander bzw. des jeweiligen Kühlmittelkanal 20 wirken zweckmäßig Federkräfte, die beispielsweise mit Hilfe von Zugankern 33 erzeugt werden. Beispielsweise zeigen die Fig. 3 und 4 Ausführungsformen, bei welchen die beiden Kühlmittelkanäle 20 mit Hilfe von mehreren Zugankern 33 aufeinander zu vorgespannt. Hierzu kann der jeweilige Zuganker 33 z.B. zumindest an einem seiner Enden oder zwischen seinen Enden wenigstens ein Federelement 34 aufweisen. Beispielsweise kann das jeweilige Federelement 34 im Fall der Fig. 4 durch eine Wellbalgfeder 36 gebildet sein. Grundsätzlich sind auch andere geeignete Federelemente 34 denkbar, z.B. in einer Wellfeder, einer C-Feder, einer Ω-Feder oder einer Rohrfeder.

Die Zuganker 33 sind gemäß Fig. 3 zweckmäßig möglichst gleichmäßig verteilt, um eine gleichmäßige Vorspannung der Kühlmittelkanäle gegeneinander zu erzielen. Gemäß Fig. 4 durchdringen die Zuganker 33 den jeweiligen Kühlmittelkanal 20, um sich an der jeweiligen, vom Abgaskanal 16 abgewandten Seite abzustützen.

Grundsätzlich ist es auch möglich, die beiden Kühlmittelkanäle 20 zu einem gemeinsamen Schalengehäuse zusammenzufassen, so dass dann die beiden Kühlmittelkanäle 20 jeweils eine Gehäuseschale bilden. Diese als Gehäuseschalen ausgestaltete Kühlmittelkanäle 20 können die übrigen Komponenten des Abgaskrümmers 15, also insbesondere die thermoelektrischen Wandler 22 und den Abgaskanal 16 wie ein gemeinsames Gehäuse umschließen. In Randbereichen können diese Gehäuseschalen-Kühlmittelkanäle 20 aneinander anliegen und mit Hilfe von Federelementen aufeinander zu vorgespannt sein bzw. mit Hilfe entsprechender Befestigungselemente aneinander fixiert sein. Die federelastische Vorspannung kann dann durch die Materialelastizität der Gehäuseschalen-Kühlmittelkanäle 20 selbst erzeugt werden. Rein exemplarisch können die Gehäuseschalen-Kühlmittelkanäle 20 mittels C-förmiger oder U-förmiger oder Ω-förmiger Klammern aufeinander zu vorgespannt und/oder aneinander fixiert werden.

Wie Fig. 4 entnehmbar ist, sind die einzelnen thermoelektrischen Wandler 22 zweckmäßig von einer thermischen Isolation 37 ringförmig umschlossen. Dabei umgibt die jeweilige Isolation 37 den jeweiligen thermoelektrischen Wandler 22 umfangsmäßig, also entlang eines seitlichen Rands, der sich zwischen den beiden voneinander abgewandten axialen Stirnseiten des jeweiligen thermoelektrischen Wandlers 22 befindet, über welche Stirnseiten der jeweilige thermoelektrische Wandler 22 flächig mit dem Abgaskanal 16 bzw. mit dem jeweiligen Kühlmittelkanal 20 kontaktiert ist.

Die wärmeübertragende Kontaktierung zwischen dem jeweiligen thermoelektrischen Wandler 22 und dem Abgaskanal 16 einerseits und zwischen den jeweiligen thermoelektrischen Wandler 22 und dem jeweiligen Kühlmittelkanal 20 andererseits kann über einen direkten körperlichen Kontakt oder vorzugsweise über ein Wärmeleitmaterial erfolgen, wobei das jeweilige Wärmeleitmaterial beispielsweise in Form einer Paste oder in Form eines Formkörpers oder in Form einer Folie realisiert werden kann.

Die Isolation 37, welche die thermoelektrischen Wandler 22 umschließt, kann als Formkörper konfiguriert sein, der gleichzeitig zur Positionierung der thermoelektrischen Wandler 22 genutzt werden kann. Ferner kann in diesem Formkörper die Verkabelung 23 integriert sein. So vereinfacht sich die Herstellung des Abgaskrümmers 15.

Entsprechend Fig. 4 kann bei einer vorteilhaften Ausführungsform vorgesehen sein, dass der Abgaskanal 16 an seiner von den thermoelektrischen Wandlern 22 abgewandten bzw. dem Abgas zugewandten Innenseite wenigstens eine Versteifungsstruktur 44 zur Aussteifung des Abgaskanals 16 aufweist. Eine derartige Versteifungsstruktur 44 kann beispielsweise durch eine Rippe oder ein Steg gebildet sein. Durch die Aussteifung des Abgaskanals 16 können vergleichsweise große Drücke bzw. Vorspannungen am Abgaskanal 16 abgestützt werden, um über die Kühlmittelkanäle 20 die thermoelektrischen Wandler 22 an die Kühlmittelkanäle 20 und an den Abgaskanal 16 anzudrücken. Besonders vorteilhaft ist im Beispiel zumindest eine solche Versteifungsstruktur 44 so ausgestaltet, z.B. in Form eines Stabs oder einer Säule, dass sie zwei einander gegenüberliegende Wände des Abgaskanals 16 aneinander abstützt. Hierdurch lassen sich besonders große Kräfte abstützen, während gleichzeitig die Wände des Abgaskanals 16 vergleichsweise dünne Wandstärken aufweisen können.

Zusätzlich oder alternativ kann vorgesehen sein, dass der Abgaskanal 16 an seiner Innenseite wenigstens eine Wärmeübertragungsstruktur 45 zur Verbesserung der Wärmeübertragung zwischen Abgaskanal 16 und Abgas aufweist. Geeignete Wärmeübertragungsstrukturen 45 sind z.B. Turbulatoren, Rippen, Lamellen, Leitbleche, Finnen und dergleichen. Im gezeigten Beispiel ist zumindest die stabförmige oder säulenförmige Versteifungsstruktur 44 außerdem so konzipiert, das sie als Wärmeübertragungsstruktur 45 wirkt. Hierdurch erhält die Versteifungsstruktur 44 eine Doppelfunktion, ohne mehr Bauraum zu benötigen. In Fig. 3 sind rein exemplarisch mehrere solche als Stab, Säule oder Stütze ausgestaltete Versteifungsstrukturen 44 angedeutet, die gleichzeitig als Wärmeübertragungsstrukturen 45 dienen können. Hierzu können die stabförmigen Versteifungsstrukturen 44 mit Lamellen oder Leitblechen oder Rippen versehen sein. Ferner ist eine sich über mehrere Zylinder 3 ersteckende Versteifungsstruktur 44 erkennbar, die ebenfalls als Wärmeübertragungsstruktur 45 konzipiert sein kann.

Gemäß Fig. 5 kann der jeweilige Kühlmittelkanal 20 zumindest eine Außenschale 38 zum Abstützen der Vorspannkräfte und eine Innenschale 39 zum Abstützen des jeweiligen Kühlmittelkanals 20 am jeweiligen thermoelektrischen Wandler 22 aufweisen. Die Ausgestaltung des jeweiligen Kühlmittelkanals 20 als mehrteiliger Schalenkörper ermöglicht es z.B. die Außenschale 38 als Druckkörper auszugestalten und die Innenschale 39 als Vorspannkörper auszugestalten. Die Außenschale 38 besitzt dann zweckmäßig im Vergleich zur Innenschale 39 eine erhöhte Biegesteifigkeit. Dies kann beispielsweise durch eine größere Wandstärke und/oder durch Versteifungsrippen und dergleichen realisiert werden. Im Unterschied dazu kann die Innenschale 39 eine Vorspannkontur 40 aufweisen. Im Beispiel der Fig. 5 hat diese Vorspannkontur die Form einer dem Abgaskanal 16 zugewandten konvexen Wölbung. Die Ausgestaltung der Außenschale 38 als Druckkörper oder Druckplatte vereinfacht die Erzeugung der gewünschten Vorspannung, da eine derartige Druckplatte hinreichend steif und somit selbsttragend konzipiert werden kann. Die federnd nachgiebige Ausgestaltung der Innenschale 39 verbessert die homogene Anpressung des jeweiligen thermoelektrischen Wandlers 22 einerseits gegen den Abgaskanal 16 und andererseits gegen den jeweiligen Kühlmittelkanal 20.

In Fig. 4 sind die Vorspannkräfte, mit denen der jeweilige Kühlmittelkanal 20 den jeweiligen thermoelektrischen Wandler 22 gegen den Abgaskanal 16 andrücken, durch Pfeile 16 angedeutet. Wie sich Fig. 4 außerdem entnehmen lässt, sind die Zuganker 33, mit denen die beiden Kühlmittelkanäle 20 zum Erzeugen der Vorspannkräfte 46 aufeinanderzu vorgespannt sind, jeweils durch die beiden Kühlmittelkanäle 20 hindurchgeführt. Hierzu ist im jeweiligen Kühlmittelkanal 20 eine Hülse 47 vorgesehen, die sich in einem Innenraum 48 des Kühlmittelkanals 20 von der Außenseite 38 zur Innenseite 39 erstreckt und dabei eine Durchgangsöffnung 49 umschließt bzw. definiert. Die Hülse 47 trennt dadurch den vom Kühlmittel durchströmbaren Inneraum 48 von der Durchgangsöffnung 49. Durch die jeweilige Durchgangsöffnung 49 kann nun ein solcher Zuganker 33 hindurchgeführt werden, derart, dass sich der jeweilige Zuganker 33 dann an einer von der Innenschale 39 abgewandten Außenseite der Außenschale 38 abstützen kann. Die Abstützung zwischen Außenschale 38 und Zuganker 33 erfolgt im gezeigten Beispiel der Fig. 4 durch Formschluss. Hierzu besitzt die jeweilige Durchgangsöffnung 49 an der Außenschale 38 eine trichterförmige Einlaufkontur 50. Das zugehörige Ende des Zugankers 33 ist dazu komplementär geformt. Bei einem rohrförmigen Zuganker 33 kann diese Kontur besonders einfach durch eine trichterartige Aufweitung realisiert werden. Im Beispiel der Fig. 4 ist der jeweilige Zuganker 33 mehrteilig und umfasst z.B. zwei Rohrstücke 51, 52, die mithilfe des Federelements 34 miteinander verbunden sind und aufeinanderzu vorgespannt sind.

In den Fig. 3 und 4 sind ein zum jeweiligen Kühlmittelkanal 20 hinführender Vorlaufanschluss 41 und ein vom jeweiligen Kühlmittelkanal 20 wegführender Rücklaufanschluss 42 erkennbar, über welche der jeweilige Kühlmittelkanal an den jeweiligen Kühlkreis 6 bzw. 28 anschließbar ist. In Fig. 3 ist eine besondere Ausführungsform wiedergegeben, bei welcher die Anschlüsse 41 und 42 dazu genutzt werden, den jeweiligen Kühlmittelkanal 20 an einen Kühlkreis 43 anzuschließen, an den auch der Abgasturbolader 11 angeschlossen ist. Hierdurch kann insbesondere eine hinsichtlich der Kühlmittelführung integrierte Baugruppe geschaffen werden, was den Aufwand zur Kühlmittelführung reduziert. Beim Kühlkreis 43 zur Kühlung des Abgasturboladers 11 kann es sich um den Kühlkreis 6 der Brennkraftmaschine 1 handeln oder um einen Nebenzweig dieses Kühlkreises 6. Ebenso kann es ich um den vom Kühlkreis 6 der Brennkraftmaschine 1 unabhängig steuerbaren Kühlkreis 28 handeln.

Für einen Kaltstartbetrieb wird die Brennkraftmaschine 1 zweckmäßig so betrieben, dass die Steuerung 26 den Konverter 24 so ansteuert, dass dieser die thermoelektrischen Wandler 22 zur Nutzung des Peltier-Effekts betreibt. Hierzu legt der Konverter 24 über die Verkabelung 23 eine elektrische Spannung an die thermoelektrischen Wandler 22 an, die der Konverter 24 vorzugsweise vom Energiespeicher 25 bezieht. Die so betriebenen thermoelektrischen Wandler 22 wandeln nun die elektrische Energie in Wärme um und können dadurch den Abgaskanal 16 aufheizen. Hierdurch trägt der hier vorgestellte Abgaskrümmer 15 zur Verkürzung des Kaltstartbetriebs bei.

Während des normalen Warmbetriebs der Brennkraftmaschine 1 werden dann die thermoelektrischen Wandler 22 zur Nutzung des Seebeck-Effekts betrieben, also zum Erzeugen elektrischer Energie, die dann über den Konverter 24 den Verbrauchern 27 bzw. dem Speicher 25 zugeführt werden kann.

Die Wirkungsweise der thermoelektrischen Wandler 22 beruht im Normalbetrieb auf dem Seebeck-Effekt, so dass ein Wärmetransport zu einem Stromfluss führt. Beim Inversbetrieb führt dagegen ein Stromfluss zu einem Wärmetransport, was auf dem Peltier-Effekt beruht.

## Patentansprüche

1. Abgaskrümmer für eine Abgasanlage (5) einer Brennkraftmaschine (1), insbesondere eines Kraftfahrzeugs,
- mit einem Abgaskanal (16) zur Abgasführung, der eine an die Brennkraftmaschine (1) anschließbare Einlassseite (17) und eine an die Abgasanlage (5) anschließbare Auslassseite (19) aufweist,
- mit wenigstens einem Kühlmittelkanal (20) zur Kühlmittelführung, der außen am Abgaskanal (16) angeordnet und an einen Kühlkreis (6) anschließbar ist,
- mit wenigstens einem thermoelektrischen Wandler (22), der einerseits mit dem Abgaskanal (16) und andererseits mit dem Kühlmittelkanal (20) wärmeübertragend gekoppelt ist,
**dadurch gekennzeichnet,**
- **dass** zumindest ein solcher Kühlmittelkanal (20) als Druckkörper ausgestaltet ist und den thermoelektrischen Wandler (22) gegen den Abgaskanal (16) andrückt, insbesondere mittels Federkraft,
- **dass** der jeweilige Kühlmittelkanal (20) zumindest eine Außenschale (38) zum Abstützen von Vorspannkräften (46) und eine Innenschale (39) zum Abstützen des jeweiligen Kühlmittelkanals (20) am jeweiligen thermoelektrischen Wandler (22) aufweist,
- **dass** zumindest ein Zuganker (33) zum Einleiten der Vorspannkräfte (46) in die jeweilige Außenschale (38) vorgesehen ist, der beim jeweiligen Kühlmittelkanal (20) die Innenschale (39) und die Außenschale (38) durchsetzt und an einer von der Innenschale (39) abgewandten Außenseite der Außenschale (38) abgestützt ist.

2. Abgaskrümmer nach Anspruch 1,
**dadurch gekennzeichnet,**
**dass** eine Steuerung zum Betreiben des wenigstens einen thermoelektrischen Wandlers (22) vorgesehen ist, die während eines Warmbetriebs der Brennkraftmaschine (1) den jeweiligen thermoelektrischen Wandler (22) zum Erzeugen elektrischer Energie betreibt und die während eines Kaltstartbetriebs der Brennkraftmaschine (1) den jeweiligen thermoelektrischen Wandler (22) zum Erzeugen von Wärme betreibt.

3. Abgaskrümmer nach Anspruch 1 oder 2,
**dadurch gekennzeichnet,**
**dass** der jeweilige Kühlmittelkanal (20) für den jeweiligen Zuganker (33) eine Hülse (47) aufweist, die eine vom jeweiligen Zuganker (33) durchsetzte Durchgangsöffnung (49) von einem vom Kühlmittel durchströmbaren Innenraum (48) des jeweiligen Kühlmittelkanals (20) trennt.

4. Abgaskrümmer nach einem der Ansprüche 1 bis 3,
**dadurch gekennzeichnet,**
**dass** zumindest zwei als Druckkörper ausgestaltete Kühlmittelkanäle (20) vorgesehen sind, zwischen denen der Abgaskanal (16) und der jeweilige thermoelektrische Wandler (22) angeordnet sind und die aufeinanderzu vorgespannt sind, insbesondere mittels Federkraft, um den thermoelektrischen Wandler (22) gegen den Abgaskanal (16) anzudrücken.

5. Abgaskrümmer nach Anspruch 4,
**dadurch gekennzeichnet,**
- **dass** zwischen den beiden als Druckkörper ausgestalteten Kühlmittelkanälen (20) zumindest zwei thermoelektrische Wandler (22) beiderseits des Abgaskanals (16) angeordnet und mit Hilfe der Kühlmittelkanäle (20) gegeneinander angedrückt sind, und/oder
- **dass** die beiden Kühlmittelkanäle (20) mit Hilfe von wenigstens einem Zuganker (33) aufeinander zu vorgespannt sind.

6. Abgaskrümmer nach einem der Ansprüche 1 bis 5,
**dadurch gekennzeichnet,**
**dass** der jeweilige Zuganker (33) zumindest ein Federelement (31) aufweist oder durch wenigstens ein Federelement (31) gebildet ist, wobei das jeweilige Federelement (31) insbesondere als Wellfeder, als Wellbalgfeder, als C-Feder, als Ω-Feder oder als Rohrfeder ausgestaltet sein kann.

7. Abgaskrümmer nach einem der Ansprüche 1 bis 6,
**dadurch gekennzeichnet,**
**dass** der jeweilige thermoelektrische Wandler (22) zwischen dem Abgaskanal (16) und dem jeweiligen Kühlmittelkanal (20) von einer thermischen Isolation (39) ringförmig umschlossen ist, wobei insbesondere vorgesehen sein kann, dass benachbarte thermoelektrische Wandler (22) gegeneinander thermisch isoliert sind.

8. Abgaskrümmer nach einem der Ansprüche 1 bis 7,
**dadurch gekennzeichnet,**
- **dass** entlang der Außenseite des Abgaskanals (16) verteilt mehrere thermoelektrische Wandler (22) angeordnet sind, die über eine Verkabelung (23) elektrisch miteinander verbunden sind, und/oder
- **dass** der jeweilige thermoelektrische Wandler (22) an eine elektrische Verkabelung (23) angeschlossen ist, die aus dem Abgaskrümmer (15) herausgeführt ist.

9. Abgaskrümmer nach einem der Ansprüche 1 bis 8,
**dadurch gekennzeichnet,**
- **dass** der Abgaskanal (16) an seiner Innenseite wenigstens eine Versteifungsstruktur (44) zur Aussteifung des Abgaskanals (16) aufweist, wobei insbesondere vorgesehen sein kann, dass zumindest eine solche Versteifungsstruktur (44) zwei einander gegenüberliegende Wände des Abgaskanals (16) aneinander abstützt, und/oder
- **dass** der Abgaskanal (16) an seiner Innenseite wenigstens eine Wärmeübertragungsstruktur (45) zur Verbesserung der Wärmeübertragung zwischen Abgaskanal (16) und Abgas aufweist, und/oder
- **dass** der Abgaskanal (16) an seiner Innenseite wenigstens eine Versteifungsstruktur (44) zur Aussteifung des Abgaskanals (16) aufweist, die außerdem als Wärmeübertragungsstruktur (45) zur Verbesserung der Wärmeübertragung zwischen Abgaskanal (16) und Abgas ausgestaltet ist, wobei insbesondere vorgesehen sein kann, dass zumindest eine solche Versteifungsstruktur (44) zwei einander gegenüberliegende Wände des Abgaskanals (16) aneinander abstützt.

10. Brennkraftmaschine, insbesondere eines Kraftfahrzeugs,
- mit mindestens einem Abgaskrümmer (15) nach einem der Ansprüche 1 bis 9,
- mit mindestens einer an den Abgaskrümmer (15) angeschlossenen Abgasanlage (5),
- wobei der jeweilige Kühlmittelkanal (20) an einen Kühlkreis (6) angeschlossen ist,
- wobei die Brennkraftmaschine (1) einen Kühlkreis (6) zur Kühlung eines Motorblocks (2) der Brennkraftmaschine (1) aufweist, wobei der jeweilige Kühlmittelkanal (20) an den Kühlkreis (6) der Brennkraftmaschine oder an einen separat vom Kühlkreis (6) der Brennkraftmaschine (1) steuerbaren Kühlkreis angeschlossen ist.

11. Brennkraftmaschine nach Anspruch 10,
**dadurch gekennzeichnet,**
- **dass** der an den jeweiligen Kühlmittelkanal (20) angeschlossene Kühlkreis eine Kühlmittelpumpe aufweist, wobei eine Steuerung vorgesehen ist, die eine Förderleistung der Kühlmittelpumpe abhängig vom Kühlbedarf des jeweiligen Kühlmittelkanals (20) steuert, und/oder
- **dass** ein Abgasturboladers vorgesehen ist, der an einen Kühlkreis angeschlossen ist, wobei der jeweilige Kühlmittelkanal (20) an denselben Kühlkreis angeschlossen ist, an den auch der Abgasturbolader angeschlossen ist.

12. Verfahren zum Betreiben einer Brennkraftmaschine (1) nach einem der Ansprüche 10 und 11,
- bei dem während eines Warmbetriebs der Brennkraftmaschine (1) der jeweilige thermoelektrische Wandler (22) zum Erzeugen elektrischer Energie betrieben wird,
- bei dem während eines Kaltstartbetriebs der Brennkraftmaschine (1) der jeweilige thermoelektrische Wandler (22) zum Erzeugen von Wärme betrieben wird.

## Claims

1. Exhaust manifold for an exhaust system (5) of an internal combustion engine (1), in particular for a motor vehicle, comprising:
- an exhaust channel (16), for conducting exhaust gas, which comprises an inlet side (17) which can be connected to the internal combustion engine (1) and an outlet side (19) which can be connected to the exhaust system (5),
- at least one coolant channel (20), for conducting coolant, which is arranged on the outside of the exhaust channel (16) and can be connected to a cooling circuit (6),
- at least one thermoelectric transducer (22) which is coupled on the one hand to the exhaust channel (16) and on the other hand to the coolant channel (20) in a heat-transferring manner,
**characterised in that**,
- at least one coolant channel (20) of this type is configured as a pressure body and presses the thermoelectric transducer (22) against the exhaust channel (16), in particular by means of spring force,
- the respective coolant channel (20) comprises at least one outer shell (38) for supporting pre-loading forces (46) and an inner shell (39) for supporting the respective coolant channel (20) on the respective thermoelectric transducer (22),
- at least one tension rod (33) for introducing the preloading forces (46) into the respective outer shell (38) is provided, which rod penetrates the inner shell (39) and the outer shell (38) of the respective coolant channel (20) and is supported on an outer side of the outer shell (38) facing away from the inner shell (39).

2. Exhaust manifold according to claim 1, **characterised in that** a control means for operating the at least one thermoelectric transducer (22) is provided, which control means, during hot operation of the internal combustion engine (1), operates the respective thermoelectric transducer (22) for generating electrical energy and which, during a cold start operation of the internal combustion engine (1), operates the respective thermoelectric transducer (22) for generating heat.

3. Exhaust manifold according to either claim 1 or claim 2, **characterised in that** the respective coolant channel (20) comprises a sleeve (47) for the respective tension rod (33), which sleeve separates a through-opening (49) penetrated by the respective tension rod (33) from an interior space (48), through which coolant can flow, of the respective coolant channel (20).

4. Exhaust manifold according to any of claims 1 to 3, **characterised in that** at least two coolant channels (20) configured as pressure bodies are provided, between which the exhaust channel (16) and the respective thermoelectric transducer (22) are arranged and which are preloaded towards each other, in particular by means of spring force, in order to press the thermoelectric transducer (22) against the exhaust channel (16).

5. Exhaust manifold according to claim 4, **characterised in that**
- between the two coolant channels (20) configured as pressure bodies, at least two thermoelectric transducers (22) are arranged on either side of the exhaust channel (16) and are pressed against each other with the aid of the coolant channels (20), and/or **in that**
- the two coolant channels (20) are preloaded towards each other with the aid of at least one tension rod (33).

6. Exhaust manifold according to any of claims 1 to 5, **characterised in that** the respective tension rod (33) comprises at least one spring element (31) or is formed by at least one spring element (31), it being possible to configure the respective spring element (31) as a wave spring, a pneumatic wave spring, a C-spring, a Ω-spring or a pipe spring.

7. Exhaust manifold according to any of claims 1 to 6, **characterised in that** the respective thermoelectric transducer (22) is annularly enclosed by a piece of thermal insulation (39) between the exhaust channel (16) and the respective coolant channel (20), it being possible to provide in particular for adjacent thermoelectric transducers (22) to be thermally insulated with respect to each other.

8. Exhaust manifold according to any of claims 1 to 7, **characterised in that**
- a plurality of thermoelectric transducers (22) are distributed along the outside of the exhaust channel (16) and are electrically interconnected via cabling (23), and/or **in that**
- the respective thermoelectric transducer (22) is connected to electrical cabling (23), which is led out of the exhaust manifold (15).

9. Exhaust manifold according to any of claims 1 to 8, **characterised in that**
- the exhaust channel (16) comprises on the inside thereof at least one reinforcing structure (44) for reinforcing the exhaust channel (16), it being possible to provide in particular for at least one such reinforcing structure (44) to support two opposing walls of the exhaust channel (16) on each other, and/or **in that**
- the exhaust channel (16) comprises on the inside thereof at least one heat transfer structure (45) for improving the heat transfer between exhaust channel (16) and exhaust gas, and/or **in that**
- the exhaust channel (16) comprises on the inside thereof at least one reinforcing structure (44) for reinforcing the exhaust channel (16), which in addition is configured as a heat transfer structure (45) for improving the heat transfer between exhaust channel (16) and exhaust gas, it being possible to provide in particular for at least one such reinforcing structure (44) to support two opposing walls of the exhaust channel (16) on each other.

10. Internal combustion engine, in particular for a motor vehicle, comprising:
- at least one exhaust manifold (15) according to any of claims 1 to 9,
- at least one exhaust system (5) connected to the exhaust manifold (15);
- wherein the respective coolant channel (20) is connected to a cooling circuit (6);
- wherein the internal combustion engine (1) comprises a cooling circuit (6) for cooling an engine block (2) of the internal combustion engine (1), wherein the respective coolant channel (20) is connected to the cooling circuit (6) of the internal combustion engine, or to a cooling circuit that can be controlled separately from the cooling circuit (6) of the internal combustion engine (1).

11. Internal combustion engine according to claim 10, **characterised in that**
- the cooling circuit connected to the respective coolant channel (20) comprises a coolant pump, a control means being provided which controls a delivery rate of the coolant pump depending on the cooling requirement of the respective coolant channel (20), and/or **in that**
- an exhaust gas turbocharger is provided which is connected to a cooling circuit, the respective coolant channel (20) being connected to the same cooling circuit to which the exhaust gas turbocharger is also connected.

12. Method for operating an internal combustion engine (1) according to any of claims 10 and 11,
- wherein during hot operation of the internal combustion engine (1) the respective thermoelectric transducer (22) is operated for generating electric energy;
- wherein during a cold start operation of the internal combustion engine (1), the respective thermoelectric transducer (22) is operated for generating heat.

## Revendications

1. Collecteur de gaz d'échappement pour un système d'échappement (5) d'un moteur à combustion interne (1), en particulier d'un véhicule automobile,
- avec un conduit de gaz d'échappement (16) pour conduire des gaz d'échappement, qui présente un côté admission (17) pouvant être raccordé au moteur à combustion interne (1) et un côté évacuation (19) pouvant être raccordé au système d'échappement (5),
- avec au moins un conduit de réfrigérant (20) pour conduire un réfrigérant qui est disposé à l'extérieur sur le conduit de gaz d'échappement (16) et qui peut être raccordé à un circuit de refroidissement (6),
- avec au moins un convertisseur thermoélectrique (22) qui est couplé en transmission de chaleur et raccordé d'un côté au conduit de gaz d'échappement (16) et d'un autre côté au conduit de réfrigérant (20),
**caractérisé en ce que**
- au moins un tel conduit de réfrigérant (20) est constitué en sous forme d'un corps de pression et presse le convertisseur thermoélectrique (22) contre le conduit de gaz d'échappement (16), en particulier sous l'action de la force de ressort,
- **en ce que** le conduit de réfrigérant (20) respectif présente au moins une coque extérieure (38) pour supporter des forces de précontrainte (46) et une coque intérieure (39) pour supporter le conduit de réfrigérant (20) respectif sur le convertisseur thermoélectrique (22) respectif,
- **en ce qu'**il est prévu au moins un tirant d'ancrage (33) pour introduire les forces de précontrainte (46) dans la coque extérieure (38) respective, qui, au niveau du conduit de réfrigérant (20) respectif, traverse la coque intérieure (39) et la coque extérieure (38) et qui est supporté sur un côté extérieur de la coque extérieure (38) opposé à la coque intérieure (39)

2. Collecteur de gaz d'échappement selon la revendication 1,
**caractérisé en ce**
**qu'**il est prévu une commande pour le fonctionnement d'au moins un convertisseur thermoélectrique (22), qui, pendant un fonctionnement à chaud du moteur à combustion interne (1), fait fonctionner le convertisseur thermoélectrique (22) respectif pour produire de l'énergie électrique et qui, pendant un fonctionnement de démarrage à froid du moteur à combustion interne (1), fait fonctionner le convertisseur thermoélectrique (22) respectif pour produire de la chaleur.

3. Collecteur de gaz d'échappement selon la revendication 1 ou 2
**caractérisé en ce que**
le conduit de réfrigérant (20) respectif présente pour le tirant d'ancrage (33) respectif une douille (47) réalisant une séparation entre une ouverture de passage (49) traversée par le tirant d'ancrage (33) respectif et un espace intérieur (48) du conduit de réfrigérant (20) respectif qui peut être parcouru par le réfrigérant.

4. Collecteur de gaz d'échappement selon l'une des revendications 1 à 3,
**caractérisé en ce**
**qu'**il est prévu au moins deux conduits de réfrigérant (20) constitués en tant que corps de pression, entre lesquels sont disposés le conduit de gaz d'échappement (16) et le convertisseur thermoélectrique (22) respectif et qui sont précontraints l'un vers l'autre, en particulier au moyen d'une force de ressort, pour presser le convertisseur thermoélectrique (22) contre le conduit de gaz d'échappement (16).

5. Collecteur de gaz d'échappement selon la revendication 4,
**caractérisé en ce que**,
- entre les deux conduits de réfrigérant (20) constitués en tant que corps de pression, au moins deux convertisseurs thermoélectriques (22) sont disposés des deux côtés du conduit de gaz d'échappement (16) et sont pressés l'un contre l'autre à l'aide des conduits de réfrigérant (20), et/ou
- **en ce que** les deux conduits de réfrigérant (20) sont précontraints l'un vers l'autre à l'aide d'au moins un tirant d'ancrage (33).

6. Collecteur de gaz d'échappement selon l'une des revendications 1 à 5,
**caractérisé en ce que**
le tirant d'ancrage (33) respectif présente au moins un élément de ressort (31) ou est formé d'au moins un élément de ressort (31), l'élément de ressort (31) respectif pouvant être constitué en particulier en tant que ressort ondulé, en tant que ressort à soufflet ondulé, en tant que ressort en C, en tant que ressort en Ω ou en tant que ressort tubulaire.

7. Collecteur de gaz d'échappement selon l'une des revendications 1 à 6,
**caractérisé en ce**
**que** le convertisseur thermoélectrique (22) respectif, entre le conduit de gaz d'échappement (16) et le conduit de réfrigérant (20) respectif, est entouré de façon annulaire par une isolation thermique (39), avec en particulier la possibilité de prévoir que des convertisseurs thermoélectriques (22) voisins soient thermiquement isolés les uns par rapport aux autres.

8. Collecteur de gaz d'échappement selon l'une des revendications 1 à 7,
**caractérisé en ce que**,
- plusieurs convertisseurs thermoélectriques (22) sont disposés de façon répartie le long du côté extérieur du conduit de gaz d'échappement (16) et sont raccordés électriquement entre eux par le biais d'un câblage (23), et/ou
- **en ce que** le convertisseur thermoélectrique (22) respectif est raccordé à un câblage électrique (23) en provenance du collecteur de gaz d'échappement (15).

9. Collecteur de gaz d'échappement selon l'une des revendications 1 à 8,
**caractérisé en ce que**
- le conduit de gaz d'échappement (16) présente sur son côté intérieur au moins une structure de renfort (44) destinée à renforcer le conduit de gaz d'échappement (16), avec en particulier la possibilité de prévoir qu'au moins une telle structure de renfort (44) supporte l'une contre l'autre deux parois du conduit de gaz d'échappement (16) opposées l'une à l'autre et/ou
- **en ce que** le conduit de gaz d'échappement (16) présente, sur son côté intérieur, au moins une structure de transmission de chaleur (45) pour améliorer la transmission de chaleur entre le conduit de gaz d'échappement (16) et les gaz d'échappement, et/ou
- **en ce que** le conduit de gaz d'échappement (16) présente, sur son côté intérieur, au moins une structure de renfort (44) destinée à renforcer le conduit de gaz d'échappement (16) et qui est en outre constituée en tant que structure de transmission de chaleur (45) permettant d'améliorer la transmission de chaleur entre le conduit de gaz d'échappement (16) et les gaz d'échappement, avec en particulier la possibilité de prévoir qu'au moins une telle structure de renfort (44) supporte l'une contre l'autre deux parois du conduit de gaz d'échappement (16) opposées l'une à l'autre.

10. Moteur à combustion interne, en particulier d'un véhicule automobile,
- avec au moins un collecteur de gaz d'échappement (15) selon l'une des revendications 1 à 9,
- avec au moins un système d'échappement (5) raccordé au collecteur de gaz d'échappement (15),
- le conduit de réfrigérant (20) respectif étant raccordé à un circuit de refroidissement (6),
- le moteur à combustion interne (1) présentant un circuit de refroidissement (6) pour le refroidissement d'un bloc-moteur (2) du moteur à combustion interne (1), le conduit de réfrigérant (20) respectif étant raccordé au circuit de refroidissement (6) du moteur à combustion interne ou à un circuit de refroidissement pouvant être commandé séparément du circuit de refroidissement (6) du moteur à combustion interne (1).

11. Moteur à combustion interne selon la revendication 10,
**caractérisé en ce que**
- le circuit de refroidissement raccordé au conduit de réfrigérant (20) respectif présente une pompe de réfrigérant, avec une commande étant prévue qui commande un débit de la pompe de réfrigérant en fonction du besoin de refroidissement du conduit de réfrigérant (20) respectif, et/ou
- **en ce qu'**il est prévu un turbocompresseur à gaz d'échappement qui est raccordé à un circuit de refroidissement, le conduit de réfrigérant (20) respectif étant raccordé au même circuit de refroidissement que celui auquel est également raccordé le turbocompresseur à gaz d'échappement.

12. Procédé de fonctionnement d'un moteur à combustion interne (1) selon l'une des revendications 10 et 11,
- dans lequel, lors du fonctionnement à chaud du moteur à combustion interne (1), le convertisseur thermoélectrique (22) respectif fonctionne pour produire de l'énergie électrique,
- dans lequel, pendant un fonctionnement de démarrage à froid du moteur à combustion interne (1), le convertisseur thermoélectrique (22) respectif fonctionne pour produire de la chaleur.
